# EUROPEAN PATENT APPLICATION

(11) **EP 4 502 202 A1**
(43) Date of publication of application: **05.02.2025**
(21) Application number: 23779189.2
(22) Date of filing: 02.03.2023
(51) Int. Cl.: C22C 5/04, C22C 9/00, C22C 9/06, C22C 30/02, C22C 19/03, C22F 1/00, C22F 1/08, C22F 1/10, C22F 1/14, G01R 1/06

(54) **ALLOY MATERIAL FOR PROBE PINS**

(30) Priority: 29.03.2022 JP 2022052781
(71) Applicant: Ishifuku Metal Industry Co., Ltd., Chiyoda-ku, Tokyo 101-0047 (JP); Yokowo Co., Ltd, Tokyo 101-0041 (JP)
(72) Inventor: HASEGAWA Koichi, Soka-shi, Saitama 340-0002 (JP); EGAWA Yasunori, Soka-shi, Saitama 340-0002 (JP); MATSUZAWA Atsuo, Soka-shi, Saitama 340-0002 (JP); SATO Kenichi, Tomioka-Shi, Gunma 370-2495 (JP)
(74) Representative: TBK
(86) International application number: PCT/JP2023/007737
(87) International publication number: WO 2023/189160

(57) **Abstract**

An object of the present invention is to provide an alloy material for probe pins that can suppress diffusion of components between solder in a circuit connecting portion of an inspection target and a probe material during probe inspection. The alloy material for probe pins of the present invention includes more than 20 mass% and 60 mass% or less of Pd, 3 mass% or more and less than 20 mass% of Ag, 3 mass% or more and 50 mass% or less of Ni, and 3 mass% or more and 74 mass% or less of Cu. Alternatively, the alloy material for probe pins of the present invention includes more than 20 mass% and 60 mass% or less of Pd, 20 mass% or more and 35 mass% or less of Ag, 7 mass% or more and 50 mass% or less of Ni, and 3 mass% or more and 53 mass% or less of Cu.

## Description

### Technical Field

The present invention relates to an alloy material for probe pins (hereinafter referred to as "probe material") for inspecting the electrical characteristics of an integrated circuit on a semiconductor wafer, a liquid crystal display device, or the like.

### Background Art

For inspection of the electrical characteristics of an integrated circuit formed on a semiconductor wafer, a liquid crystal display device, or the like, a socket or a probe card in which a plurality of probes are incorporated has been used. This inspection is performed by bringing probe pins incorporated in the socket or the probe card into contact with an electrode, a terminal, or a conductive portion of the integrated circuit, the liquid crystal display device, or the like.

Such probe pins are required to have low contact resistance and hardness enough to withstand repeated contact. For example, a beryllium-copper alloy, tungsten, a tungsten alloy, a platinum alloy, or a palladium alloy is used as a probe material.

In US 1935897 A, there is a disclosure of a palladium alloy (hereinafter referred to as "AgPdCu alloy") composed of not less than 16% and not more than 50% copper, palladium ranging from about 35% to about 59%, and silver to the extent of not less than 4%.

### Citation List

### Patent Literature

[PTL 1] US 1935897 A

### Summary of Invention

### Technical Problem

The AgPdCu alloy, which has excellent plastic workability and is precipitation-hardened, has hitherto been used as the probe material because of its shape stability resulting from its hardness and low specific resistance characteristics. However, the following problem has been found when such probe material is used in a circuit connecting portion where solder (e.g., Sn-Bi-based solder) is used. Specifically, during inspection, a probe pin and the solder are repeatedly brought into contact with each other, and an electrical current flows therebetween. As a result, a solder component such as Sn and a component of the probe material interdiffuse due to the resulting Joule heat or the like, and a tip end of the probe pin tends to be rapidly consumed. In such case, contact resistance varies suddenly or over time, resulting in the occurrence of an inspection defect. Accordingly, cleaning or exchange of a tip end portion of the probe pin to be brought into contact is required, and there has been a problem in that the operating rate of an inspection step is reduced.

In view of the foregoing, there is a strong demand for development of a probe material having solder resistance sufficient to suppress the diffusion of the solder component.

An object of the present invention is to provide a probe material that can suppress diffusion of components between solder in a circuit connecting portion of an inspection target and the probe material during probe inspection.

### Solution to Problem

The inventors of the present invention have found a probe material consisting of more than 20 mass% and 60 mass% or less of Pd, 3 mass% or more and less than 20 mass% of Ag, 3 mass% or more and 50 mass% or less of Ni, and 3 mass% or more and 74 mass% or less of Cu, and thus completed the present invention.

The inventors of the present invention have also found a probe material consisting of more than 20 mass% and 60 mass% or less of Pd, 20 mass% or more and 35 mass% or less of Ag, 7 mass% or more and 50 mass% or less of Ni, and 3 mass% or more and 53 mass% or less of Cu, and thus completed the present invention.

The probe material may include 0.2 mass% or more and 2.0 mass% or less in total of at least one kind of In, Sn, Zn, and Ga instead of a portion of Cu.

### Advantageous Effects of Invention

According to the present invention, the probe material, which suppresses diffusion of components between solder in a circuit connecting portion of an inspection target and the probe material during inspection, can be provided.

### Description of Embodiments

A first aspect of the present invention is directed to a probe material consisting of more than 20 mass% and 60 mass% or less of Pd, 3 mass% or more and less than 20 mass% of Ag, 3 mass% or more and 50 mass% or less of Ni, and 3 mass% or more and 74 mass% or less of Cu.

In addition, a second aspect of the present invention is directed to a probe material consisting of more than 20 mass% and 60 mass% or less of Pd, 20 mass% or more and 35 mass% or less of Ag, 7 mass% or more and 50 mass% or less of Ni, and 3 mass% or more and 53 mass% or less of Cu.

The probe material may include 0.2 mass% or more and 2.0 mass% or less in total of at least one kind of In, Sn, Zn, and Ga in place of part of Cu.

Pd has excellent corrosion resistance. However, when the content of Pd is 20 mass% or less, its corrosion resistance becomes insufficient. Meanwhile, when the content of Pd is more than 60 mass%, it is not suitable because diffusion of components between solder and the probe material cannot be sufficiently suppressed.

As another embodiment, the content of Pd may be from 22 mass% to 55 mass%. In addition, as another embodiment, the content of Pd may be from 25 mass% to 50 mass%.

Adding Ni to the alloy enhances its solder resistance. Experimental results indicate that the necessary amount of Ni depends on the Ag content.

In the first aspect of the present invention, the addition amount of Ag is as small as less than 20 mass%. In such a case, when the addition amount of Ni is less than 3 mass%, diffusion of components between the solder and the probe material cannot be sufficiently suppressed, and when the addition amount of Ni is more than 50 mass%, plastic working processes such as cold rolling or wire drawing become difficult.

In the second aspect of the present invention, the addition amount of Ag is as large as 20 mass% or more. In such a case, when the addition amount of Ni is less than 7 mass%, diffusion of components between the solder and the probe material cannot be sufficiently suppressed, and when the addition amount of Ni is more than 50 mass%, plastic working processes such as cold rolling or wire drawing become difficult.

In the first aspect of the present invention, the content of Ni may be from 5 mass% to 40 mass% as another embodiment. Additionally, in another embodiment, the content of Ni may be from 7 mass% to 35 mass%.

In the second aspect of the present invention, the content of Ni may be from 8 mass% to 40 mass% as another embodiment. Additionally, in another embodiment, the content of Ni may be from 10 mass% to 35 mass%. In a further embodiment, the content of Ni may be from 11 mass% to 35 mass%.

When added in combination with Pd and Cu, Ag improves age hardening. However, a content of Ag less than 3 mass% is not suitable because the effect is not sufficient. Further, a content of Ag more than 35 mass% is also unsuitable because it does not sufficiently suppress the diffusion of components between the solder and the probe material.

In the first aspect of the present invention, the content of Ag may be from 4 mass% to 18 mass% as another embodiment.

In the second aspect of the present invention, the content of Ag may be from 21 mass% to 33 mass% as another embodiment.

Cu has low specific resistance, and besides, Cu has an increasing effect on hardness when alloyed with Pd. However, when Cu is added in a large amount, the corrosion resistance is reduced. Specifically, when the content of Cu is less than 3 mass%, sufficient hardness is not obtained, and when the content of Cu is more than 74 mass%, the corrosion resistance is reduced.

In the first of the present invention, the content of Cu may be from 5 mass% to 70 mass% as another embodiment. Additionally, in another embodiment, the content of Cu may be from 10 mass% to 60 mass%. In a further embodiment, the content of Cu may be from 15 mass% to 50 mass%.

In the second of the present invention, the content of Cu may be from 5 mass% to 47 mass% as another embodiment. Additionally, in another embodiment, the content of Cu may be from 10 mass% to 40 mass%.

When at least one kind of In, Sn, Zn, and Ga is added, the age hardening is further improved. However, when at least one kind of In, Sn, Zn, and Ga is added at less than 0.2 mass%, there is no substantial difference from a no-addition case. When at least one kind of In, Sn, Zn, and Ga is added at more than 2 mass%, it becomes difficult to perform plastic working, such as cold rolling or wire drawing.

The total content of at least one kind of In, Sn, Zn, and Ga may be from 0.3 mass% to 1.5 mass% as another embodiment.

It is important for an alloy material of the present invention to suppress a phenomenon in which a tip end of a probe pin is consumed through diffusion of components between the solder and the probe material; however, the alloy material of the present invention is not required to have hardness as high as that of an existing AgPdCu alloy. Nevertheless, its contact surface may be mechanically deformed with repeated inspections, and hence it is desired that the alloy be hard. An alloy material is functional as a probe pin at a hardness of 200 HV or more, but the alloy material of the present invention achieves a hardness of 250 HV or more. The hardness may be achieved by work hardening through working, and as well, by an increase in hardness through aging.

The mechanism by which diffusion of components between the solder and the probe material is suppressed in the alloy material of the present invention is presumed as described below. Specifically, it is conceived that Ni added to the probe material forms a thin and dense intermetallic compound layer of, for example, Sn-Ni at an interface where the solder and the probe pin are brought into contact with each other. This intermetallic compound layer exhibits a preventing effect on the diffusion of components between the solder and the probe material, and thus suppress easy consumption of the tip end of the probe pin.

### Examples

### Examples of the present invention are described.

First, Ag, Pd, Cu, Ni, In, Sn, Zn, and Ga were mixed so as to achieve the compositions shown in Table 1. The mixture was then melted in an argon atmosphere by an arc melting method to produce alloy ingots. The compositions and respective characteristics of alloys of Examples and Comparative Examples are shown in Table 1.

Each of the produced alloy ingots was repeatedly subjected to rolling and heat treatment to produce a sheet material having a reduction ratio [= ((thickness before rolling - thickness after rolling) / thickness before rolling) × 100] of 75%, and the produced sheet material was used as a test piece for evaluating hardness and solder resistance.

During the production of the sheet material, an evaluation of workability was conducted as follows: an alloy composition capable of producing a sheet material with a reduction ratio of 75% was indicated with the symbol "o"; conversely, compositions that failed to achieve this reduction ratio were indicated with the symbol "×". Any alloy composition that could not produce a sheet material with a reduction ratio of 75% and had its workability rated as "×" (specifically Comparative Example 4 and Comparative Example 9) was not subjected to subsequent tests.

The produced test pieces of the alloys were each subjected to the following evaluations, and the results are shown in Table 2.

The hardness in the center of the cross section of the test piece was measured with a micro Vickers hardness tester under the conditions of a load of 200 gf and a holding time of 10 seconds. The hardness measured is referred to as "worked material hardness" in Table 2. In addition, the test piece was subjected to aging treatment at a temperature of 300°C - 400°C for 1 hour (referred to as "aged material"), and then the hardness in the center of the cross section of the aged material was measured with the micro Vickers hardness tester under the conditions of a load of 200 gf and a holding time of 10 seconds. The hardness measured is referred to as "aged material hardness" in Table 2.

The solder resistance was evaluated as described below. Sn-Bi-based solder was applied onto the test piece (with the size of 10 mm × 10 mm × 0.5 mm in thickness), and the solder on the test piece was melted through heat treatment in a N₂ atmosphere under the conditions of 250°C and 1 hour. After the heat treatment, the test piece was embedded in a resin and a cross section thereof was exposed. An interface between the solder and the test piece was subjected to line analysis in a vertical direction with an EPMA. A layer in which Sn and Pd coexisted through interdiffusion between Sn from the solder and Pd from the alloy was regarded as a diffusion layer, and the thickness of the diffusion layer was measured.

It was evaluated that the smaller the thickness of the measured diffusion layer, the higher the solder resistance. Specifically, alloys were evaluated as follows: an alloy forming a diffusion layer having a thickness of less than 100 um was indicated with the symbol "oo"; an alloy forming a diffusion layer having a thickness of from 100 um to 200 um was indicated with the symbol "o"; and an alloy forming a diffusion layer having a thickness of more than 200 um was indicated with the symbol "×". The evaluation results are shown in Table 2.

The specific resistance was evaluated as described below. A sheet material processed so as to have a reduction ratio [ = ((thickness before rolling - thickness after rolling) / thickness before rolling) × 100] of 90% was used as a test piece for evaluating the specific resistance. The specific resistance was calculated by measuring the electrical resistance of each test piece at room temperature, according to Equation 1. Equation 1: Specific resistance = (Electrical resistance × Cross sectional area) / Measurement length

**Table 1**

| No. | Composition (mass%) | | | | | | | | Workability |
|---|---|---|---|---|---|---|---|---|---|
| | Ag | Pd | Cu | Ni | In | Sn | Zn | Ga | |
| Example 1 | 3 | 45 | 42 | 10 | | | | | ○ |
| Example 2 | 5 | 43 | 42 | 10 | | | | | ○ |
| Example 3 | 15 | 33 | 42 | 10 | | | | | ○ |
| Example 4 | 20 | 30 | 40 | 10 | | | | | ○ |
| Example 5 | 30 | 30 | 30 | 10 | | | | | ○ |
| Example 6 | 10 | 38 | 22 | 30 | | | | | ○ |
| Example 7 | 10 | 45 | 40 | 5 | | | | | ○ |
| Example 8 | 25 | 40 | 25 | 10 | | | | | ○ |
| Example 9 | 25 | 30 | 15 | 30 | | | | | ○ |
| Example 10 | 10 | 40 | 39.5 | 10 | | 0.5 | | | ○ |
| Example 11 | 10 | 40 | 39.5 | 10 | | | 0.5 | | ○ |
| Example 12 | 10 | 40 | 39.5 | 10 | | | | 0.5 | ○ |
| Example 13 | 10 | 40 | 39.2 | 10 | 0.2 | 0.2 | 0.2 | 0.2 | ○ |
| Example 14 | 10 | 40 | 38.5 | 10 | 1.5 | | | | ○ |
| Example 15 | 22 | 40.5 | 27 | 10 | 0.5 | | | | ○ |
| Example 16 | 25 | 40 | 24.5 | 10 | | 0.5 | | | ○ |
| Example 17 | 25 | 40 | 24.5 | 10 | | | 0.5 | | ○ |
| Example 18 | 25 | 40 | 24.5 | 10 | | | | 0.5 | ○ |
| Example 19 | 25 | 40 | 24.2 | 10 | 0.2 | 0.2 | 0.2 | 0.2 | ○ |
| Example 20 | 25 | 40 | 23.5 | 10 | 1.5 | | | | ○ |
| Comparative Example 1 | 24.5 | 45 | 30 | | 0.5 | | | | ○ |
| Comparative Example 2 | 40 | 30 | 20 | 10 | | | | | ○ |
| Comparative Example 3 | 10 | 47 | 42 | 1 | | | | | ○ |
| Comparative Example 4 | 10 | 20 | 10 | 60 | | | | | × |
| Comparative Example 5 | 25 | 40 | 29 | 6 | | | | | ○ |
| Comparative Example 6 | 24.3 | 44.5 | 29.7 | 1 | 0.5 | | | | ○ |
| Comparative Example 7 | 23.8 | 43.6 | 29.1 | 3 | 0.5 | | | | ○ |
| Comparative Example 8 | 23.3 | 42.7 | 28.5 | 5 | 0.5 | | | | ○ |
| Comparative Example 9 | 25 | 40 | 22.5 | 10 | 2.5 | | | | × |
| Comparative Example 10 | | 75 | 15 | 10 | | | | | ○ |

**Table 2**

| No. | Specific resistance µΩ·cm | Worked material hardness HV | Aged material hardness HV | Thickness of diffusion layer µm | Evaluation of thickness of diffusion layer |
|---|---|---|---|---|---|
| Example 1 | 46 | 300 | 320 | 20 | ○○ |
| Example 2 | 44 | 310 | 330 | 20 | ○○ |
| Example 3 | 46 | 290 | 330 | 15 | ○○ |
| Example 4 | 44 | 300 | 330 | 45 | ○○ |
| Example 5 | 44 | 280 | 320 | 65 | ○○ |
| Example 6 | 38 | 350 | 370 | 10 | ○○ |
| Example 7 | 35 | 330 | 350 | 25 | ○○ |
| Example 8 | 30 | 320 | 350 | 40 | ○○ |
| Example 9 | 25 | 320 | 340 | 10 | ○○ |
| Example 10 | 39 | 340 | 370 | 20 | ○○ |
| Example 11 | 38 | 330 | 360 | 20 | ○○ |
| Example 12 | 41 | 330 | 370 | 20 | ○○ |
| Example 13 | 40 | 330 | 380 | 15 | ○○ |
| Example 14 | 42 | 340 | 360 | 30 | ○○ |
| Example 15 | 34 | 330 | 370 | 15 | ○○ |
| Example 16 | 39 | 320 | 370 | 20 | ○○ |
| Example 17 | 38 | 310 | 360 | 25 | ○○ |
| Example 18 | 29 | 320 | 360 | 20 | ○○ |
| Example 19 | 30 | 320 | 370 | 20 | ○○ |
| Example 20 | 38 | 340 | 360 | 30 | ○○ |
| Comparative Example 1 | 25 | 350 | 550 | 600 or more | × |
| Comparative Example 2 | 39 | 270 | 320 | 215 | × |
| Comparative Example 3 | 27 | 320 | 340 | 600 or more | × |
| Comparative Example 5 | 28 | 320 | 360 | 240 | × |
| Comparative Example 6 | 26 | 340 | 540 | 370 | × |
| Comparative Example 7 | 31 | 350 | 460 | 600 or more | × |
| Comparative Example 8 | 27 | 340 | 410 | 360 | × |
| Comparative Example 10 | 43 | 290 | 300 | 600 or more | × |

It is found from the above-mentioned results that the alloys produced according to the present invention each have high solder resistance, and also have hardness, age hardening ability, and specific resistance required for a probe material. Consequently, according to the present invention, the alloy material suitable as a probe material having solder resistance can be provided.

## Claims

1. An alloy material for probe pins, consisting of:
more than 20 mass% and 60 mass% or less of Pd;
3 mass% or more and less than 20 mass% of Ag;
3 mass% or more and 50 mass% or less of Ni; and
3 mass% or more and 74 mass% or less of Cu.

2. The alloy material for probe pins according to claim 1, comprising 0.2 mass% or more and 2.0 mass% or less of at least one kind of In, Sn, Zn, and Ga in place of part of Cu.

3. An alloy material for probe pins, consisting of:
more than 20 mass% and 60 mass% or less of Pd;
20 mass% or more and 35 mass% or less of Ag;
7 mass% or more and 50 mass% or less of Ni; and
3 mass% or more and 53 mass% or less of Cu.

4. The alloy material for probe pins according to claim 3, comprising 0.2 mass% or more and 2.0 mass% or less of at least one kind of In, Sn, Zn, and Ga in place of part of Cu.
